# EUROPEAN PATENT APPLICATION

(11) **EP 4 343 356 A1**
(43) Date of publication of application: **27.03.2024**
(21) Application number: 22197279.7
(22) Date of filing: 23.09.2022
(51) Int. Cl.: G01R 33/48, G01R 33/44, G01R 33/24, G01R 33/565, G01R 33/56, G01R 33/561

(54) **MR IMAGING WITH WATER/FAT/B0 MAPPING**

(71) Applicant: Koninklijke Philips N.V., 5656 AG Eindhoven (NL)
(72) Inventor: RUDRAPATNA, Umesh Suryanarayana, Eindhoven (NL); KASIREDDY, Viswanatha Reddy, Eindhoven (NL); NAGARAJ, Suthambhara, 5656AG Eindhoven (NL); NEELAVALLI, Jaladhar, 5656AG Eindhoven (NL); JAYAPALAN, Manivannan, Eindhoven (NL); SARASWATHY, Suja, Eindhoven (NL); THAZHACKAL, Sharun S, Eindhoven (NL)
(74) Representative: Philips Intellectual Property & Standards

(57) **Abstract**

The invention relates to a method of MR imaging of an object (10) placed in a main magnetic field (B₀) within an examination volume of an MR system (1). It is an object of the invention to provide an improved MR imaging technique in which B₀ mapping is performed with no or only minimal additional scan time. The method of the invention comprises the steps of: subjecting the object (10) to a first imaging sequence to generate a first set of MR signals at a first echo time, acquiring the first set of MR signals from the object (10), subjecting the object (10) to a second imaging sequence to generate a second set of MR signals at a second echo time which is different from the first echo time, wherein the first and second imaging sequences further differ with respect to at least one of: field of view, image resolution, repetition time, k-space sampling pattern, relaxation time weighting, acquiring the second set of MR signals from the object (10), and deriving a water map, a fat map, and a B₀ map from the first and second sets of MR signals using a Dixon method. Moreover, the invention relates to an MR system (1) and to a computer program to be run on an MR system (1).

## Description

### FIELD OF THE INVENTION

The invention relates to the field of magnetic resonance (MR) imaging. It concerns a method of MR imaging of an object placed in a main magnetic field within an examination volume of an MR system. The invention also relates to an MR system and to a computer program to be run on an MR system.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

Ensuring geometric accuracy of MR images is crucial for many applications. Geometric distortion of clinical MR images needs to be assessed and corrected if necessary. System-level distortions are sufficiently corrected in state-of-the-art MR systems, but the subject-induced distortions due to susceptibility and chemical shift effects still need to be accounted for and corrected.

A common approach for quantifying and correcting subject-induced geometric distortions is to acquire a map of the main magnetic field (Bo map) in a separate pre-scan, i.e. prior to the acquisition of the actual MR image. The Bo map is used to assess the inhomogeneity of the main magnetic field from the phase difference of two gradient echo images acquired at different echo times.

The Bo map can be used to correct for main field inhomogeneity during processing of the acquired MR signals so as to reduce or eliminate geometrical distortions in the reconstructed MR images. This applies in particular to imaging techniques such as EPI (echo planar imaging) and to techniques that use non-Cartesian k-space trajectories, such as spiral k-space scans.

Alternatively (or additionally), a minimization of Bo inhomogeneity can be achieved in a process called B₀ shimming. Shimming uses electric currents applied to dedicated coils that generate corrections to the main magnetic field in the examination volume of the MR system, making the field inside that volume as uniform as possible. Those corrections are generated in the form of field gradients of different geometries. The process of adjusting the currents passing through the shim coils is referred to as shimming and can be performed any time. In particular, the determined Bo map can be used to derive appropriate shimming currents to compensate for any detected main field inhomogeneity. J.P. Stockmann et al. (Neuroimage, 168:71-87, 2018) discuss several hardware approaches for static and dynamic Bo shimming using either higher order spherical harmonics shim coils or multi coil shim arrays, adaptive current networks are used for active shimming. Such shimming techniques can also effect a significant improvement of the signal-to-noise ratio (SNR). However, shimming has inherent limitations and cannot correct all Bo inhomogeneities. The determined Bo map can thus be helpful to assess any remaining inhomogeneity after shimming. Such a residual Bo map is still useful for distortion and blurring correction during reconstruction.

Estimation of the Bo map faces several challenges, some of which are common to all body sites, such as poor signal-to-noise ratio and phase-wrapping at locations with large susceptibility effects, and others that are more relevant for specific body portions, such as chemical shift. Due to signal contributions from fat and water protons, the Bo map can be corrupted by chemical shift artefacts, particularly for body sites with substantial fat content.

More advanced methods for Bo determination estimate the Bo map as well as fat and water contributions, thereby reducing or essentially eliminating chemical shift artefacts. The relative contributions from fat and water to the MR signal can be calculated if information from two or more corresponding echoes, acquired at different echo times, is combined. This can be considered as chemical shift encoding, in which an additional dimension, the chemical shift dimension, is defined and encoded by acquiring two or more MR images at slightly different echo times. For water/fat separation, these types of experiments are often referred to as Dixon-type of measurements. By means of Dixon MR imaging or Dixon water/fat MR imaging, a water/fat separation is achieved by calculating contributions of water and fat from two or more corresponding echoes, acquired at different echo times. In general, this separation is possible because there is a known precessional frequency difference of hydrogen in fat and water.

Several Dixon-type MR imaging methods have been proposed in recent years. Apart from different strategies for the water/fat separation, the known techniques are mainly characterized by the specific number of echoes (or 'points') they acquire and by the constraints that they impose on the used echo times. Conventional methods require in-phase and opposed-phase echo times at which the water and fat signals are parallel and antiparallel in the complex plane, respectively. Three- and two-point methods have gradually been generalized to allow flexible echo times. Thus, they do not restrict the angle or phase between the water and fat signals at the echo times to certain values anymore. In this way, they provide more freedom in imaging sequence design and enable in particular a trade-off between signal-to-noise ratio (SNR) gains from the acquisition and SNR losses in the separation. On the other hand, sampling only two instead of three echoes is desirable to reduce scan time (see Eggers et al., Magn. Reson. Med., 65:96-107, 2011).

These known approaches principally succeed in correcting/suppressing artefacts related to main field inhomogeneity and chemical shift. However, the acquisition of a Bo map in a pre-scan (i.e. in a separate scan executed prior to the main scan) requires additional scan time and the correction/suppression of inhomogeneity-induced artefacts fails if motion occurs between the pre-scan and the main scan.

### SUMMARY OF THE INVENTION

It is an object of the invention to provide an improved MR imaging technique in which Bo mapping is performed with no or only minimal additional scan time.

In accordance with the invention, a method of MR imaging of an object placed in a main magnetic field within an examination volume of an MR system is proposed, wherein the method comprises the steps of:
- subjecting the object to a first imaging sequence to generate a first set of MR signals at a first echo time,
- acquiring the first set of MR signals from the object,
- subjecting the object to a second imaging sequence to generate a second set of MR signals at a second echo time which is different from the first echo time, wherein the first and second imaging sequences further differ with respect to at least one of: field of view, image resolution, repetition time, k-space sampling pattern, relaxation time weighting,
- acquiring the second set of MR signals from the object, and
- deriving a water map, a fat map, and a Bo map from the first and second sets of MR signals.

The known Dixon approach, as mentioned above, is based on acquiring MR signal data at least at two different echo times and using computation to separate water and fat signal contributions and determine the Bo map. The invention generalizes this concept with no additional acquisition step, namely by utilizing MR signal data acquired at two or more different echo times, but also using two (or more) different (first and second) imaging sequences. The first and second imaging sequences correspond to different (gradient echo) acquisitions. They may differ with respect to the field of view, the image resolution, the repetition time, the k-space sampling pattern, the relaxation time weighting etc. The invention thus enables using distinct gradient echo scans for water/fat separation and Bo mapping. In this way, the method of the invention saves scan time by removing the need for an explicit Bo acquisition in a separate pre-scan.

In a possible embodiment, the first and second imaging sequences are associated with a survey scan and a calibration scan, respectively, wherein the survey scan is used to provide an overview image of the object, and wherein the calibration scan is used to determine spatial sensitivity profiles of RF receiving antennas used in acquiring the MR signals (e.g. for parallel imaging). Such survey and calibration scans are typically executed anyway at the beginning of each imaging session, so they do not involve any additional scan time. They use different imaging sequences (in terms of field of view and image resolution). The invention proposes to use the MR signal data acquired in these pre-scans for deriving the Bo map (and a water map and a fat map so as to avoid chemical shift artefacts). Since the Bo map smoothly varies in space, the coarse resolution of the survey and calibration scans is no obstacle.

In case of brain imaging, since there is no inherent water/fat confound inside the brain region, the Bo mapping may simplify to a mere phase subtraction technique. While this is conventionally done using a dedicated acquisition (Bo pre-scan), the invention eliminates that need, and instead uses already acquired data (from the survey and calibration scans) to compute the B₀ map. Further, since the imaging sequences used for the survey and calibration scans are typically factory-set protocols, they can be tailored to improve the Bo mapping.

According to the invention, the computation involved for the Bo mapping corresponds essentially to a conventional (two-point) Dixon method (see Eggers et al., J. Magn. Reson. Imaging 2014; 40:251-268). A signal model is used which includes the signal contributions from water and fat at each voxel position, the phase offset between water and fat induced by the difference in chemical shift (resulting from the chosen spectral model of fat and the two different echo time values of the first and second imaging sequences) and a (main field inhomogeneity-induced) phase error. The fundamental ambiguity in the derivation of the three unknowns of the signal model (water contribution, fat contribution, phase error) from the MR signal data associated with the two echo times can be resolved by the assumption of spatial smoothness of the main field inhomogeneity. Hence, instead of a direct calculation of the water and fat signal contributions, two-point Dixon methods typically perform the separation in three steps: First, potential solutions for the phase error are calculated. This is independently done for each voxel. Then, one solution is selected for each voxel by maximizing the spatial smoothness of the phase error and, finally, the water and fat signal contributions are estimated given the phase error.

In a possible embodiment, in which the first and second imaging sequences are different in terms of the field of view, the water map, the fat map, and the Bo map are derived for an overlap area of the fields of view of the first and second imaging sequences.

In another embodiment, the object is subjected to a third imaging sequence to generate a third set of MR signals, wherein the image resolution of the third imaging sequence is higher than the image resolution of the first and/or second imaging sequences, wherein the third set of MR signals is acquired and reconstructed into an MR image, the reconstruction involving compensation for Bo inhomogeneity based on the Bo map derived from the first and second sets of MR signals. In this embodiment, the first and second imaging sequences may represent pre-scans, such as the mentioned survey and calibration scans executed at a lower image resolution, wherein the third imaging sequence represents the main scan executed for the actual image acquisition at a higher image resolution. The Bo map derived from the MR signal data acquired using the first and second imaging sequences can be used for correcting or suppressing artefacts related to main field inhomogeneity and chemical shift in the MR image reconstructed from the MR signal data acquired using the third imaging sequence. In a possible embodiment, Bo inhomogeneity can be compensated for during the application of the third imaging sequence by shimming of the main magnetic field based on the Bo map derived according to the invention. If the first and second imaging sequences are different from each other in terms of the field of view, the field of view of the third imaging sequence (or at least that part of the field of view in which a Bo inhomogeneity compensation is desired) should be contained in the overlap area of the fields of view of the first and second imaging sequences in order to have reliable Bo data available throughout the relevant field of view of the third imaging sequence.

The method of the invention described thus far can be carried out by means of an MR system including at least one main magnet coil for generating an essentially uniform, static main magnetic field Bo within an examination volume, a number of gradient coils for generating switched magnetic field gradients in different spatial directions within the examination volume, at least one body RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstructing MR images from the received MR signals. The method of the invention can be implemented by a corresponding programming of the reconstruction unit and/or the control unit of the MR system.

The method of the invention can be advantageously carried out on most MR systems in clinical use at present. To this end it is merely necessary to utilize a computer program by which the MR system is controlled such that it performs the above-explained method steps of the invention. The computer program may be present either on a data carrier or be present in a data network so as to be downloaded for installation in the control unit of the MR system.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention.

In the drawings:
- Fig. 1: shows an MR system for carrying out the method of the invention;
- Fig. 2: shows an embodiment of the method of the invention as a flow chart;
- Fig. 3: shows a Bo map derived from survey and calibration scan data according to the invention.

### DETAILED DESCRIPTION OF THE EMBODIMENTS

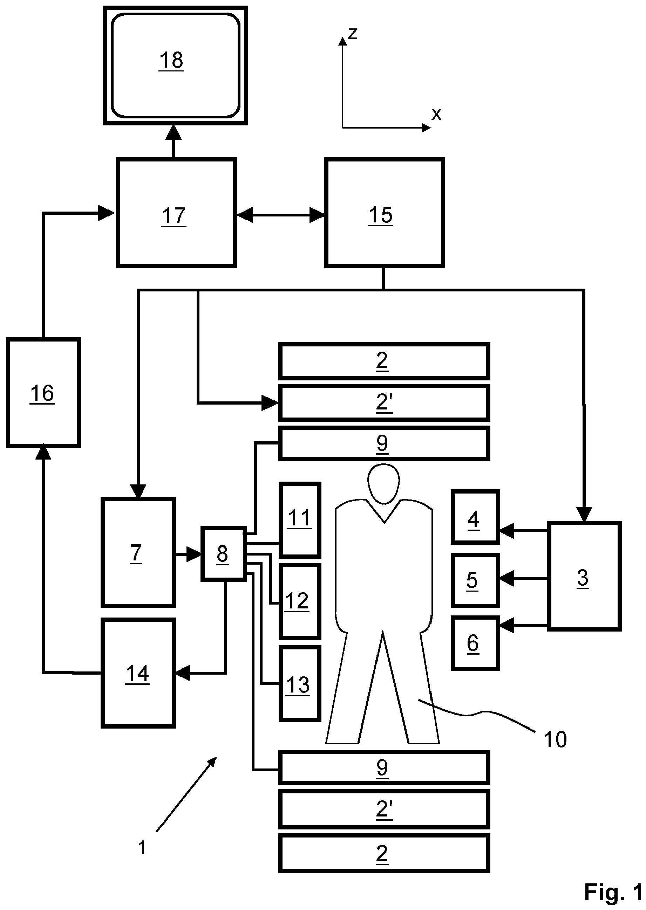

With reference to Fig. 1, an MR system 1 is shown as a block diagram. The device comprises superconducting or resistive main magnet coils 2 such that a substantially uniform, temporally constant main magnetic field Bo is created along a z-axis through an examination volume. The device further comprises a set of (1^{st}, 2^{nd}, and - where applicable - 3^{rd} order) shimming coils 2', wherein the current flow through the individual shimming coils of the set 2' is controllable for the purpose of minimizing Bo deviations within the examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send/receive switch 8 and a body RF coil 9, into the examination volume. A typical MR imaging sequence is composed of a packet of RF pulse segments of short duration which, together with any applied magnetic field gradients, achieve a selected manipulation of nuclear magnetic resonance. The RF pulses are used to saturate resonance, excite resonance, invert magnetization, refocus resonance, or manipulate resonance and select a portion of a body 10 positioned in the examination volume. The MR signals are also picked up by the body RF coil 9.

For generation of MR images of limited regions of the body 10, a set of local array RF coils 11, 12, 13 are placed contiguous to the region selected for imaging. The array coils 11, 12, 13 can be used to receive MR signals induced by RF transmissions via the body RF coil.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via the send/receive switch 8.

A host computer 15 controls the shimming coils 2' as well as the gradient pulse amplifier 3 and the transmitter 7 to generate the imaging sequences of the invention. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modern MR systems the data acquisition system 16 is a separate computer which is specialized in acquisition of raw image data.

Ultimately, the digital raw image data are reconstructed into an image representation by a reconstruction processor 17 which applies a Fourier transform or other appropriate reconstruction algorithms, such as SENSE. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

The host computer 15 and the reconstruction processor 17 are programmed to execute the method of the invention as described above and in the following.

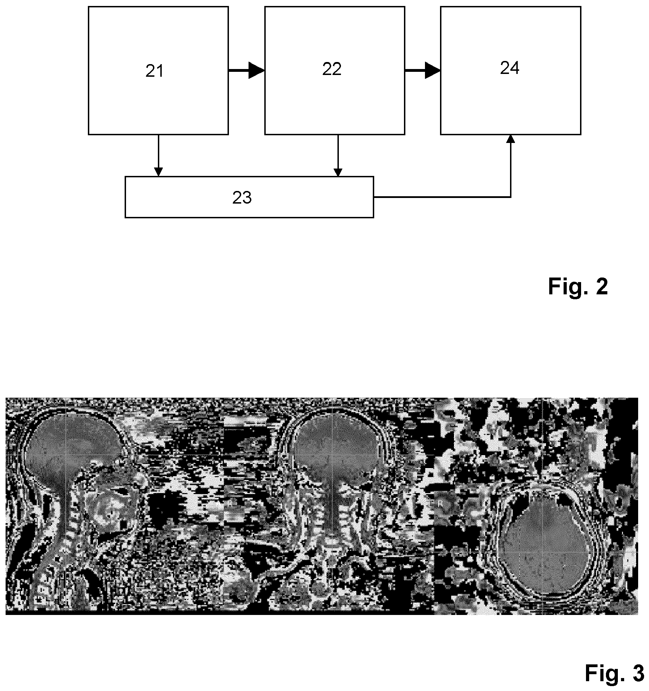

In Fig. 2, the method of the invention is illustrated as a flow chart. In Step 21, a conventional survey scan is performed using a first imaging sequence. The survey scan provides a first set of MR signals at a first echo time, wherein an overview image of the body 10 is reconstructed from the first set of MR signals. In Step 22, a conventional calibration scan is performed to determine the spatial sensitivity profiles of the RF coils 11, 12, 13 used for acquiring the MR signals. The second set of MR signals is acquired at a second echo time which is different from the first echo time, wherein the first and second imaging sequences of the survey scan and the calibration scan, respectively, further differ with respect to the image resolution and the field of view, they apply different k-space sampling patterns, they are different, independent gradient echo sequences. The (first and second sets of) MR signal data acquired in these two pre-scans are used in step 23 for deriving a Bo map, a water map and a fat map using a conventional (generalized) Dixon method. The deriving of the Bo map involves re-sampling of the complex MR signal data of at least one of the two (first and second) acquisitions to an identical, common k-space grid. Moreover, a magnitude scaling factor is applied to at least one of the (re-sampled) first and second MR signal sets to take different relaxation time weightings or other amplitude effects associated with the two different imaging sequences into account. Such scaling factors can be estimated by simulations or by calibration. These are specific for the used imaging sequences (they do not depend on the imaged object) and thus need to be determined only once in advance before actual execution of the method of the invention. Thereafter, the Bo map, the water map and the fat map are computed by a conventional (two-point) Dixon method (see above). In step 24, a third imaging sequence is applied to generate a third set of MR signals, wherein the image resolution of the third imaging sequence is higher than the image resolution of the first and second imaging sequences in steps 21, 22. The third imaging sequence represents the main scan executed for the actual image acquisition at a higher image resolution. The Bo map derived in step 23 is used for correcting or suppressing artefacts related to main field inhomogeneity and chemical shift in the MR image reconstructed from the MR signal data acquired in the main scan in step 24. The Bo map can also be used for Bo shimming during acquisition in step 24 (to reduce distortions and/or improve the SNR). Conventional B₀ eddy current correction, concomitant field correction etc. may be applied in all three acquisition steps 21, 22, 24.

Fig. 3 shows a Bo map (in three planes) derived according to the invention from a survey scan and a calibration scan in a brain imaging session. MR signal data were acquired at 3T. The echo time of the calibration scan was 0.78 ms while the echo time of the survey scan was 1.4 ms. The calibration and survey scans had different fields of view and different image resolutions. The MR signal data of the two pre-scans were brought to the same field of view and resolution during processing, i.e. prior to the application of the Dixon algorithm. The determined Bo values vary in a range of approx. 600 Hz and follow the pattern expected in the brain.

## Claims

1. Method of MR imaging of an object (10) placed in a main magnetic field (Bo) within an examination volume of an MR system (1), the method comprising the steps of:
- subjecting the object (10) to a first imaging sequence to generate a first set of MR signals at a first echo time,
- acquiring the first set of MR signals from the object (10),
- subjecting the object (10) to a second imaging sequence to generate a second set of MR signals at a second echo time which is different from the first echo time, wherein the first and second imaging sequences further differ with respect to at least one of: field of view, image resolution, repetition time, k-space sampling pattern, relaxation time weighting,
- acquiring the second set of MR signals from the object (10), and
- deriving a water map, a fat map, and a Bo map from the first and second sets of MR signals using a Dixon method.

2. Method of claim 1, wherein the water map, the fat map, and the Bo map are derived for an overlap area of the fields of view of the first and second imaging sequences.

3. Method according to claim 1 or 2, wherein the object (10) is subjected to a third imaging sequence to generate a third set of MR signals, wherein the image resolution of the third imaging sequence is higher than the image resolution of the first and/or second imaging sequences, wherein the third set of MR signals is acquired and reconstructed into an MR image, the reconstruction involving compensation for Bo inhomogeneity based on the Bo map derived from the first and second sets of MR signals.

4. Method according to claim 1 or 2, wherein the object (10) is subjected to a third imaging sequence to generate a third set of MR signals, wherein the third set of MR signals is acquired and reconstructed into an MR image, with Bo inhomogeneity being compensated for by shimming of the main magnetic field based on the Bo map derived from the first and second sets of MR signals.

5. Method of any one of claims 2-4, wherein the field of view of the third imaging sequence is contained in the overlap area of the fields of view of the first and second imaging sequences.

6. Method of any one of claims 1-5, wherein first and second imaging sequences are associated with a survey scan and a calibration scan, respectively, wherein the survey scan is used to provide an overview image of the object, and wherein the calibration scan is used to determine spatial sensitivity profiles of RF receiving antennas used in acquiring the MR signals.

7. Method of any one of claims 1-6, wherein the deriving of the water map, the fat map, and the Bo map involves re-sampling of at least one of the first and second sets of MR signals to an identical, common k-space grid.

8. Method of any one of claims 1-7, wherein the deriving of the water map, the fat map, and the Bo map involves re-scaling of at least one of the first and second sets of MR signals.

9. MR system comprising at least one main magnet coil (2) for generating a uniform, static main magnetic field Bo within an examination volume, a number of gradient coils (4, 5, 6) for generating switched magnetic field gradients in different spatial directions within the examination volume, at least one RF coil (9) for generating RF pulses within the examination volume and/or for receiving MR signals from an object (10) positioned in the examination volume, a control unit (15) for controlling the temporal succession of RF pulses and switched magnetic field gradients, and a reconstruction unit (17) for reconstructing MR images from the received MR signals, wherein the MR system (1) is configured to perform the following steps:
- subjecting the object (10) to a first imaging sequence to generate a first set of MR signals at a first echo time,
- acquiring the first set of MR signals from the object (10),
- subjecting the object (10) to a second imaging sequence to generate a second set of MR signals at a second echo time which is different from the first echo time, wherein the first and second imaging sequences further differ with respect to at least one of: field of view, image resolution, repetition time, k-space sampling pattern, relaxation time weighting,
- acquiring the second set of MR signals from the object (10), and
- deriving a water map, a fat map, and a Bo map from the first and second sets of MR signals using a Dixon method.

10. Computer program comprising instructions for performing the following steps when executed on a computer:
- executing a first imaging sequence to generate a first set of MR signals at a first echo time,
- acquiring the first set of MR signals,
- executing a second imaging sequence to generate a second set of MR signals at a second echo time which is different from the first echo time, wherein the first and second imaging sequences further differ with respect to at least one of: field of view, image resolution, repetition time, k-space sampling pattern, relaxation time weighting,
- acquiring the second set of MR signals, and
- deriving a water map, a fat map, and a Bo map from the first and second sets of MR signals using a Dixon method.
